# EUROPEAN PATENT SPECIFICATION

(11) **EP 3 699 605 B1**
(45) Date of publication and mention of the grant of the patent: **06.04.2022**
(21) Application number: 19158291.5
(22) Date of filing: 20.02.2019
(51) Int. Cl.: G01R 15/18

(54) **BATTERY MANAGEMENT UNIT WITH A PCB INTEGRATED FLUXGATE CURRENT SENSOR**
BATTERIEMANAGEMENTEINHEIT MIT IN DER LEITERPLATTE INTEGRIERTEM FLUXGATE-STROMSENSOR
UNITÉ DE GESTION DE BATTERIE DOTÉE D'UN CAPTEUR DE COURANT DE FLUX INTÉGRÉ À UNE CARTE DE CIRCUIT IMPRIMÉ

(43) Date of publication of application: 26.08.2020
(73) Proprietor: Samsung SDI Co., Ltd., Gyeonggi-do 17084 (KR)
(72) Inventor: Erhart, Michael, 8054 Pirka-Seiersberg (AT)
(74) Representative: Gulde & Partner

(56) References cited:
- EP-A1- 1 450 176
- WO-A1-2005/005998
- GB-A- 2 432 008
- US-A1- 2004 027 121
- US-A1- 2013 057 267
- US-B2- 9 410 985
- DAVIDE AZZONI ET AL: "Battery monitoring current sensors: The fluxgate concept", 13TH EUROPEAN CONFERENCE ON POWER ELECTRONICS AND APPLICATIONS, 2009 : EPE '09 ; 8 - 10 SEPT. 2009, BARCELONA, SPAIN, IEEE, PISCATAWAY, NJ, USA, 8 September 2009 (2009-09-08), pages 1-10, XP031541509, ISBN: 978-1-4244-4432-8
- O'DONNELL T ET AL: "Planar fluxgate current sensor integrated in printed circuit board", SENSORS AND ACTUATORS A: PHYSICAL, ELSEVIER BV, NL, vol. 129, no. 1-2, 24 May 2006 (2006-05-24), pages 20-24, XP027935520, ISSN: 0924-4247 [retrieved on 2006-05-24]

## Description

### Field of the Invention

The present invention relates to a battery management unit (BMU) with a fluxgate current sensor for measuring the current of a battery system, wherein the fluxgate current sensor is integrated into the printed circuit board (PCB) of the battery management unit. The present invention is further directed to a battery system employing the battery management unit with a PCB integrated fluxgate current sensor. The present invention still relates to a method for implementing said BMU equipped with a fluxgate current sensor into a battery system.

### Technological Background

A rechargeable or secondary battery differs from a primary battery in that it can be repeatedly charged and discharged, while the latter provides only an irreversible conversion of chemical to electrical energy. Low-capacity rechargeable batteries are used as power supply for small electronic devices, such as cellular phones, notebook computers and camcorders, while highcapacity rechargeable batteries are used as the power supply for hybrid vehicles and the like.

In general, rechargeable batteries include an electrode assembly including a positive electrode, a negative electrode, and a separator interposed between the positive and negative electrodes, a case receiving the electrode assembly, and an electrode terminal electrically connected to the electrode assembly. An electrolyte solution is injected into the case in order to enable charging and discharging of the battery via an electrochemical reaction of the positive electrode, the negative electrode, and the electrolyte solution. The shape of the case, e. g. cylindrical or rectangular, depends on the battery's intended purpose.

Rechargeable batteries may be a battery module formed of multiple battery submodules, each comprising battery cells coupled in series and/or parallel so as to provide a high energy density, e. g. for a hybrid vehicle. Such battery modules may be mechanically and electrically integrated, equipped with a thermal management system and set up for communication with each other and one or more electrical consumers to form a battery system.

For meeting the dynamic power demands of various electrical consumers connected to the battery system, a static control of battery power output and charging is not sufficient. Thus, steady or intermittent exchange of information between the battery system and the controllers of the electrical consumers is required. This information includes the battery systems actual state of charge (SoC), potential electrical performance including the actual electrical current supplied by the battery system, charging ability and internal resistance as well as actual or predicted power demands or surpluses of the consumers.

For monitoring, controlling and/or setting of the aforementioned parameters, a battery system usually comprises a battery management unit (BMU) and/or a battery management system (BMS) and/or an electronic control unit (ECU). For the sake of conciseness, the acronym BMU shall refer to any one of a BMU, a BMS, or an ECU throughout the following. A battery system may also employ several BMU's such as a main BMU and one or more ancillary BMU's. Such control units may be an integral part of the battery system and disposed within a common housing or may be part of a remote control unit communicating with the battery system via a suitable communication bus. In both cases, the control unit may communicate with the electrical consumers via a suitable communication bus, e. g. a CAN or SPI interface.

For controlling the actual electric current supplied by the battery system, a fluxgate current sensor may be employed. According to the state of the art, the fluxgate current sensor is designed separately from the PCB of the battery system's BMU. In particular, the fluxgate current sensor comprises a magnetic core and windings, both being separated from the PCB. The fluxgate current sensor is integrated in a plastic housing and has to be connected via a wiring harness and special protocols to the (main or ancillary) BMU of a battery system.

In other words, additionally to the BMU component, further components such as a wiring harness and connectors are needed, which produce additional costs with respect to both, materials and manufacturing, in particular, when the mounting process of the fluxgate sensor and its connection to the BMU are performed manually. Still in other words: employing a fluxgate current sensor in connection with a BMU or in a battery system is time-consuming and cost-intensive.

Therefore, there is a need for a current sensor, and in particular a fluxgate current sensor, that allows for both, less material requirements for its production and an improved/easier implementation into the battery system.

It is thus an object of the present invention to overcome or reduce the above-identified drawbacks of the prior art and to provide a current sensor to be employed by a BMU that can be produced with lower costs and within a shorter time as compared to the prior art. It is further an object of the invention to provide a BMU equipped with said current sensor. Moreover, it is an object of the invention to provide a battery system that comprises the BMU equipped with the current sensor according to the invention. It is further an object of the present invention to provide a method of implementing the BMU equipped with said current sensor into a battery system.

US 9,410,985 B2 discloses a printed circuit having a creep suppressor and a stack of metallization layers separated by electrically insulating layers. A metallization layer arranged above the insulating layer at least partially covers a cavity formed in the latter's top face. Prepreg arranged directly on the insulating layer below the metallization layer bonds the layers together. A magnetic core is housed in the cavity leaves at least a five micrometer gap between the cavity's vertical walls and roof and the core's facing vertical and top faces.

WO 2005/005998 A1 relates to a measuring method and measuring arrangement which are used as a magnetic measuring module comprising a magnetic core provided with at least one compensation coil (3) surrounding said core, in addition to an air gap and a core opening. A magnetic field probe is arranged in the air gap and a primary conductor conducting a current which is to be measured is guided through the opening of the magnetic core.

Azzoni, Teppan, and Carpita present in "Battery monitoring current sensors: The fluxgate concept" (13th European conference on power electronics and applications, 2009, EPE '09; 8 - 10 Sept. 2009, Barcelone, Spain, IEEE, Piscataway, NJ, USA, 8, September 2009, pages 1 - 10, XP031541509, ISBN 978-1-4244-4432-8) a new measurement principle based on a technology of type "fluxgate," which allows reaching a wide measurement range while guaranteeing an excellent accuracy. The key idea is to use the magnetic field created by the primary (battery) current acting on a saturable inductor. By measuring the intervals to reach inductor saturation and the load current and making use of a suitable microcontroller it is possible to accurately evaluate the value of the primary current for both high and low current levels.

US 2013/057267 A1 relates to a current sensor including a printed circuit and current lines. The printed circuit comprises a stack, along a vertical direction, of metallization layers mechanically separated by electrically insulating layers, and a measurement or excitation coil wound around a vertical winding axis. The coil is formed by conductive tracks made in at least one metallization layer. One or more current lines are positioned in a plane parallel to the layers and are configured to be supplied with currents to be measured. The coil comprises turns formed by conductive tracks, made in respective metallization layers, electrically connected to one another by pads passing through at least one of the electrically insulating layers, to form a coil that extends along the vertical winding axis.

O'Donnell et al. present in "Planar fluxgate current sensor integrated in printed circuit board" (Sensors and Actuators A: Physical, Elsevier, BV, NL, vol. 129, no. 1 - 2, 24 May 2006, pages 20 - 24, XP027935520, ISSN 0924-4247) the design and testing of a planar fluxgate current sensor, which is totally embedded in printed circuit board (PCB) and which is suitable for sensing currents in the printed circuit board traces. Fluxgate excitation and pickup coils are implemented as racetrack shaped copper winding in the printed circuit board internal layers.

GB 2 432 008 A describes a single saturable toroidal core having two windings on it, and an external cable carrying the current to be measured threaded through the centre of the toroid. Highfrequency excitation is applied to one of the coils, known as the primary, excitation, winding. A transformer is connected in series with the excitation coil and means are provided to extract the second harmonic current of the excitation frequency, such as a tuned transformer. A second winding, the nulling winding, is connected to the controller, which can generate a d.c. current using smoothed pulse width modulation (PWM). When current flows in the external cable, an harmonic signal is generated in the output of the tuned transformer. A current is then generated by the controller using PWM to cancel the external flux. Correct nulling is acheived when the second harmonic signal falls to zero, indicating full cancellation of the external flux in the saturable core. The PWM signal is thus an accurate measure of the external current, and the value can be converted to a current measurement and transmitted to the outside world using, for example, serial communications.

US 2004/027121 A1 concerns a printed circuit board integrated with a two-axis fluxgate sensor including a first soft magnetic core formed lengthwise in a first axial direction, a first excitation coil formed of a metal film and wound around the first soft magnetic core, a first pick-up coil formed of a metal film and wound around the first soft magnetic core and the first excitation coil, a second soft magnetic core formed lengthwise in a second axial direction, the second axial direction being perpendicular to the first axial direction, a second excitation coil formed of a metal film and wound around the second soft magnetic core, a second pick-up coil formed of a metal film and wound around the second soft magnetic core and the second excitation coil, and a pad for establishing conductivity between the first and second excitation coils and the first and second pick-up coils and an external circuit.

EP 1 450 176 A1 relates to a magnetic field sensor comprising a magnetic field sensing cell and a magnetic shield comprising at least two parts separated by an air-gap and surrounding the magnetic field sensing cell positioned in a cavity of the magnetic shield.

### Description of the Invention

One or more of the drawbacks of the prior art could be avoided or at least reduced by means of the present invention as disclosed by the independent claims. The basic idea of the present invention is to provide a concept allowing for highly integrating a current sensor such as a fluxgate current sensor on the BMU of a battery system.

One aspect of the invention is related to a battery management unit for a battery system with a conductor or a busbar, wherein the battery management unit comprises a printed circuit board and a fluxgate current sensor. The fluxgate current sensor comprises: a magnetic core with a through-hole, at least one excitation winding, at least one compensation winding, and sensor electronics.

The at least one excitation winding is wound around the magnetic core and the at least one compensation winding is wound around the magnetic core. The sensor electronics is configured to measure the magnetization of the at least one excitation winding, to generate a driving signal for driving the at least one compensation winding such that the magnetic flux in the magnetic core is cancelled out by the current in the at least one compensation winding, to generate a current flowing through the at least one compensation winding according to the driving signal, and to generate an output signal corresponding to the magnitude of an electric current *I*_{P} flowing through the through-hole of the magnetic core.

Every component of the fluxgate current sensor, in particular the magnetic core, the at least one excitation winding, the at least one compensation winding, and the sensor electronics are each integrated into the printed circuit board.

The magnetic core is arranged so on the printed circuit board that the battery management unit is mountable such into the battery system that the conductor or busbar of the battery system passes through the through-hole of the magnetic core.

Note that the busbar (not belonging to the battery management system according to the invention) has a predefined shape, in particular a predefined cross-section, and the through-hole in the core has a shape adapted to the cross-section of the conductor of busbar of the battery system.

Preferably, the core is made of a material such as iron or a material having a high magnetic permeability such as iron or soft ferrites.

In one embodiment of the invention, each of the windings comprises one or more turns, each of the turns extending in parallel to the printed circuit board around a virtual axis perpendicular to the printed circuit board.

In one embodiment of the battery management unit according to the invention, the printed circuit board comprises a plurality of layers, preferably six layers. These layers extend in stacked planes parallel to each other. For each of the windings, at most one turn extends per layer. For each of the windings, any two neighbored turns are connected to each other such that the entirety of the turns forms a winding.

In an alternative embodiment of the battery management unit according to the invention, for each of the windings, the turns of the winding are arranged on one layer of the PCB so as to form a flat spiral.

In one embodiment of the battery management unit, the printed circuit board comprises a plurality of layers, preferably six layers. The layers extend in stacked planes parallel to each other. For each of the windings, on all or a subset of said layers, a flat spiral winding is arranged. For each of the windings, any two neighbored flat spiral windings are connected to each other such that the entirety of the turns forms one winding.

According to one embodiment, the magnetic core is, apart from the through-hole, shaped as a cuboid. The magnetic core may, however, be of other shapes. Generally, the core may have any ring-shaped geometry. In this context, the term "ring-shaped" shall refer not only to toroidal shapes, but to any shape topologically equivalent to a torus, for example, a cuboid with a single through-hole.

According to one embodiment, the through-hole has a rectangular cross-section, for example, a quadratic cross-section. The through-hole may, however, also have another shape such as a circle or an ellipse.

In one embodiment of the battery management unit according to the invention, the magnetic core is passed through holes in the printed circuit board.

In one embodiment of the battery management unit, the number of holes in the printed circuit board is two. Further, the magnetic core comprises two U-shaped parts being shaped such that upon assembling the magnetic core using the U-shaped parts, one or both of the U-shaped parts can be passed through the holes in the printed circuit board such that the assembled magnetic core is passed through the two holes in the printed circuit board.

In case of a rectangular-shaped magnetic core, the edges of the "U" have, of course, to be considered not as being rounded, but as edges having a right-angled cross-section.

In one embodiment of the battery management unit according to the invention, the two U-shaped parts of the magnetic core are held together by one, two, or more spring bracket(s), an adhesive, or a housing of the battery management unit.

In one embodiment of the battery management unit according to the invention, the printed circuit board comprises two neighbored layers. The magnetic core is flat and positioned between the two layers. Each of the layers of the printed circuit board comprises a through-hole.

The through-hole of the magnetic core and the through-holes of the layers are located such relative to each other that a conductor or busbar can be passed at a time through any one of these through-holes along a virtual center axis perpendicular to the printed circuit board.

Further, for each of the windings, one half of each complete turn is arranged on one of said two layers and the other half of each complete turn is arranged on the other of said two layers.

In one embodiment of the battery management unit according to the invention, the flat magnetic core is formed as a rectangle, a square, an ellipse, or a circle.

In one embodiment of the battery management unit according to the invention, the through-hole in the flat magnetic core and the through-holes in the layers of the printed circuit board are each formed as a rectangle, a square, an ellipse, or a circle.

Another aspect of the present invention is related to a battery system, comprising one of the above-described embodiments of the battery management unit according to the invention and a conductor or busbar. The conductor or busbar is passed through the through-hole of the magnetic core.

Still another aspect of the present invention is related to a simplified method for implementing the battery management unit according to the invention with a fluxgate current sensor integrated on its printed circuit board into a battery system with a conductor or busbar. The method starts from the situation, wherein at least one end of the conductor or busbar is free, i. e., wherein one end or both ends of the conductor or busbar is/are not yet connected to connection pin(s) provided on the battery system for connecting any one of the free ends.

The method comprises the following steps:
a) passing the conductor or busbar through the through-hole of the magnetic core;
b) mounting the battery management unit into the battery system;
c) fixedly connecting the free end(s) of the conductor or busbar with its/their corresponding connection pin(s) on the battery system.

### Brief Description of the Drawings

Features will become apparent to those of ordinary skill in the art by describing in detail exemplary embodiments with reference to the attached drawings in which:
- Fig. 1: schematically shows an open-loop current sensor using only one winding and usable for measurement of alternating currents (AC);
- Fig. 2: schematically shows an AC zero-flux current sensor;
- Fig. 3: schematically illustrates a fluxgate current sensor;
- Fig. 4A: shows the hysteresis (B-field vs. *H*-field of the magnetization) of the core of a fluxgate current sensor during a duty cycle in the absence of an external magnetic field (taken from the specification of DRV401-Q1^{™} fluxgate current sensor of Texas Instruments^{™});
- Fig. 4B: shows the saturation (upper curve) and thus the direction of magnetization (lower curve) of the of a fluxgate current sensor during two duty cycles in the absence of an external magnetic field in arbitrary units (based on a figure taken from the specification of DRV401-Q1^{™} fluxgate current sensor of Texas Instruments^{™});
- Fig. 5A: shows the hysteresis (B-field vs. *H*-field of the magnetization) of the core of a fluxgate current sensor during a duty cycle in the presence of an external magnetic field (taken from the specification of DRV401-Q1^{™} fluxgate current sensor of Texas Instruments^{™});
- Fig. 5B: shows the saturation (upper curve) and thus the direction of magnetization (lower curve) of the of a fluxgate current sensor during two duty cycles in the presence of an external magnetic field in arbitrary units (based on a figure taken from the specification of DRV401-Q1^{™} fluxgate current sensor of Texas Instruments^{™});
- Fig. 6: shows schematically a 3-dimensional example of a planar winding (a flat spiral winding) wound around a core according to one embodiment of the present invention;
- Fig. 7: is a schematic cross-sectional view of a battery management system with a fluxgate current sensor according to one embodiment of the present invention;
- Fig. 8: is a longitudinal cut of a battery management system with a fluxgate current sensor according to one embodiment of the present invention;
- Fig. 9: is a schematic 3-dimensional view of a battery management system with a fluxgate current sensor according to one embodiment of the present invention;
- Fig. 10: is a schematic cross-sectional view and a longitudinal cut of a battery management system with a fluxgate current sensor according to one embodiment of the present invention.

### Detailed Description of the Invention

Reference will now be made in detail to embodiments, examples of which are illustrated in the accompanying drawings. Effects and features of the exemplary embodiments, and implementation methods thereof will be described with reference to the accompanying drawings. In the drawings, like reference numerals denote like elements, and redundant descriptions are omitted. The present invention, however, may be embodied in various different forms, and should not be construed as being limited to the illustrated embodiments. Accordingly, processes, elements, and techniques that are not considered necessary to those having ordinary skill in the art for a complete understanding of the aspects and features of the present invention may not be described. Further, in the drawings, the relative sizes of elements, layers, and regions may be exaggerated for clarity.

It will be understood that although the terms "first" and "second" are used to describe various elements, these elements should not be limited by these terms. These terms are only used to distinguish one element from another element. For example, a first element may be named a second element and, similarly, a second element may be named a first element, without departing from the scope of the present invention.

As used herein, the term "and/or" includes any and all combinations of one or more of the associated listed items. Further, the use of "may" when describing embodiments of the present invention refers to "one or more embodiments of the present invention." In the following description of embodiments of the present invention, the terms of a singular form may include plural forms unless the context clearly indicates otherwise.

As used herein, the term "substantially," "about," and similar terms are used as terms of approximation and not as terms of degree, and are intended to account for the inherent deviations in measured or calculated values that would be recognized by those of ordinary skill in the art. Further, if the term "substantially" is used in combination with a feature that could be expressed using a numeric value, the term "substantially" denotes a range of ±5%.

### Current sensors

Current sensors can be constructed based on magnetic sensors, exploiting the fact that a moving electric charge generates (induces) a magnetic field. Magnetic sensors are used in a broad range of applications such as position, alternating (AC) and direct (DC) current, or torque measurement. Hall-effect sensors are most common in magnetic field sensing, but their offset, noise, gain variation, and non-linearity limit the achievable resolution and accuracy of the system. Fluxgate magnetic sensors offer significantly higher sensitivity, lower drift, lower noise, and high linearity and enable up to 1000-times better accuracy of the measurement.

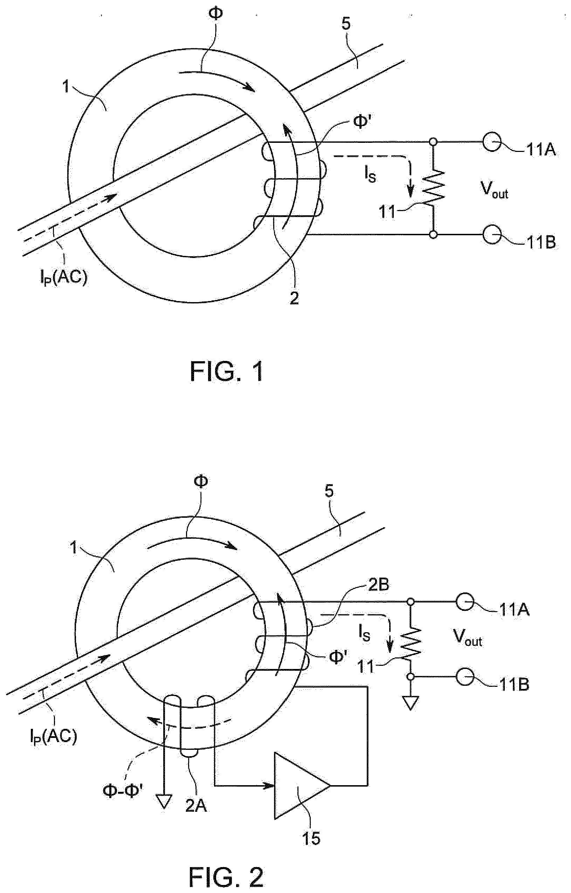

For that reason, the present invention deploys a (state-of-the-art) fluxgate current sensor. Hereinafter, the basic principles of the operating mode of a current sensor will be described with reference to Figs. 1 to 5. A current *I*_{P} to be measured flows through a conductor 5. The conductor 5 may be, for example, a busbar 110 of a battery system. The current *I*_{P} flowing through the conductor 5 produces a magnetic field corresponding to the current. If, in the area of the measurement, the conductor 5 is assumed to be shaped as a straight line, the relation between the magnetic field H (more precise: the magnetic field strength H) is given by *H* = *I*_{P} / 2π × *r,* with r denoting the distance from the conductor 5, in a region of homogeneous magnetic permeability.

The current sensor further comprises a ring-shaped core 1 formed of a material having a high magnetic permeability such as iron or soft ferrites. Throughout the following, said core may be also referred to as "magnetic core." Further, in this context, the term "ring-shaped" shall refer not only to toroidal shapes, but to any shape topologically equivalent to a torus such as a cuboid, in particular a flat cuboid, having a single through-hole. The magnetic core 1 is arranged around the conductor 5 at an area, where the current *I*_{P} shall be measured. Then, the magnetic field produced by the current *I*_{P} causes a magnetic flux Φ within the core 1, the magnetic flux Φ being proportional to the magnetic field (lines) passing through the cross-section of the core 1.

In a simple realization of a current sensor depicted in Fig. 1 - that works, however, only for measuring alternating currents (AC) -, said magnetic flux Φ is detected by a secondary coil or secondary winding 2 (the "primary side" of the circuit is formed by the conductor 5). The change of the magnetic flux Φ induces an (alternating) secondary current *I*_{S} flowing to a shunt resistor 11, producing a voltage *V*ₒᵤₜ across its terminals 11A, 11B. This voltage is the measurement circuit's output, which is proportional to the current *I*_{P} flowing in the conductor 5 being measured. A current sensor using such an arrangement is called an "open-loop current sensor," as it uses the voltage of the secondary current *I*_{S} directly to produce its output signal. This has the advantage of being simpler to implement but can suffer from a certain amount of non-linearity.

In contrast, an "AC zero-flux current sensor" as depicted in Fig. 2 is typically realized as a "closed-loop sensor," i. e., it has a winding 2B wound around the magnetic core 1 - called a "compensation winding," "compensation coil," or "feedback winding"- that is actively driven to produce a magnetic field that opposes the field produced by the current being sensed. This allows obtaining an output signal being proportional to the current driven into the compensation coil, which is in turn proportional to the current being measured. This method is more complex than the open-loop method, but it eliminates any non-linearities associated with the measurement of the magnetic flux Φ, since the measurement of the magnetic flux Φ is performed at just a single point in its range, viz. around Φ = 0.

In order to drive the compensation winding 2B as described above, the AC zero-flux current sensor has a further winding 2A - referred to as a "detection winding," "sense winding," or "measurement winding" wound likewise around the core 1 - that allows for measuring the magnetic flux Φ in the core 1 via the current being induced in the detection winding 2A, the induced current being proportional to the magnetic flux Φ in the core 1. This current is amplified, for example, by an operational amplifier 15, and then fed into the compensation winding 2B that generates a magnetic field H', which opposes the field H being generated by the current *I*_{P} to be measured. In other words, the current in the compensation winding 2B produces, corresponding to the magnetic field H' in the region of the core 1, a magnetic flux Φ' by which the flux Φ is reduced, resulting in a total magnetic flux of Φ - Φ' within the core 1. This flux is then measured by the detection winding 2A and again - after amplification - fed into the compensation winding 2B, thus forming a type of negative feedback operation such that the total magnetic flux within the core 1 becomes cancelled out.

As in the case of the current sensor of Fig. 1, the secondary current *I*_{S} (i. e., the current flowing through the compensation winding 2B) flows to a shunt resistor 11, producing a voltage across its terminals 11A, 11B. This voltage is the measurement circuit's output, which is proportional to the current *I*_{P} flowing in the conductor 5 being measured. Since the sensor operation depends on canceling out the magnetic flux in the core 5, AC zero-flux current sensors have excellent linearity and are not affected by the magnetic core's *B-H* characteristics (hysteresis). AC zero-flux sensors are well suited for use in power measurement since they are characterized by small phase error, even at low frequencies. AC zero-flux sensors have low insertion impedance since they are characterized by low operating magnetic flux levels.

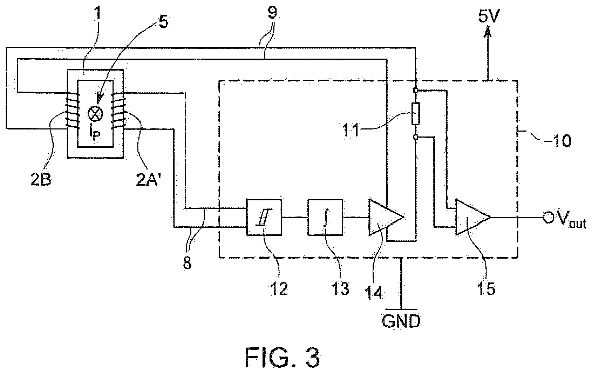

However, the AC zero-flux current sensor as depicted in Fig. 2 is still only capable of measuring the amperage of an alternating current (AC), as a current in the detection winding 2A can only be excited by a non-constant (over time) magnetic flux or, equivalently, magnetic field within the core 1. A further variant of a current sensor - a closed-loop fluxgate current sensor - is therefore illustrated in Figs. 3, 4A, 4B, 5A, and 5B, showing the basic principle of, e. g., the DRV401-Q1^{™} fluxgate current sensor of Texas Instruments^{™}.

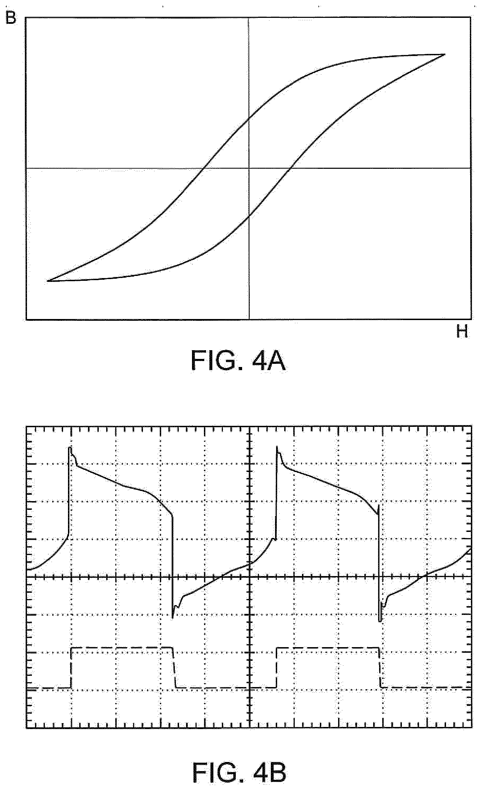

An excitation winding 2A' is wound as an inductor on a part of core 1. The excitation winding 2A' is connected to an excitation driver 12, together forming an excitation circuit 8. The excitation driver 12 causes the excitation circuit to oscillate, for example, in a frequency range between 250 kHz and 550 kHz. As the current rise rate d*I*_{exc} / dT (with respect to time T) of the current *I*_{exc} flowing through the excitation winding 2A' is proportional to the excitation winding induction L, i. e., d*I*_{exc} / d*T ~ L,* the oscillation frequency is a function of the magnetic properties of the core 1 and the excitation winding 2A'. Without external magnetic influence, the core 1 is driven from a saturation -B through the high inductance range to a saturation +*B* and back again in a fully time-symmetric manner because of the inherent symmetry of the magnetic hysteresis, as shown in Fig. 4A (arbitrary units). The saturation and thus the direction of magnetization of the core 1 is detected via the excitation driver 12, Fig. 4B (upper curve; arbitrary units). The lower curve in Fig. 4B (arbitrary units) shows the phases (i. e. the direction of magnetization) during several duty cycles (one duty cycle comprising two phases corresponding to the direction of the magnetization), wherein the two phases are of equal length.

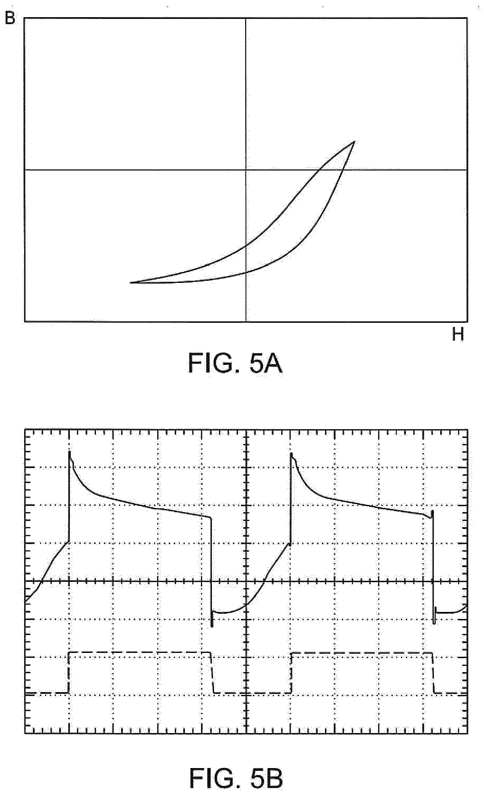

However, if the core material is pre-magnetized in one direction by the magnetic field H generated by the current *I*_{P} to be measured, a long and a short charge time with regard to the saturation result, because the current through the excitation winding 2A' generates a field *H*_{osc} - and a corresponding magnetic flux Φ_{osc} - that subtracts or adds to the magnetic flux Φ generated in the core by the current *I*_{P}, driving the core 5 out of saturation or further into saturation, as shown in Figs. 5A (hysteresis; arbitrary units) and 5B (upper curve: magnetization, lower curve: duty cycle; arbitrary units).

Thus, the magnetic flux Φ generated by the current *I*_{P} to be measured and hence the current *I*_{P} itself are related to the ratio of the length of the charge time from saturation -B of the core 1 to saturation +*B* to the length charge time from saturation +*B* to saturation -*B*; in case of Φ = 0, both charge times are equal.

These principles may now be combined with the principle of an AC zero-flux current sensor as described above with reference to Fig. 2 to achieve the advantages of a closed-loop current sensor. To that end, a compensation winding 2B is wound additionally on the core 5. The compensation winding 2B is driven by a compensation driver providing a driving current for the compensation winding 2B. The compensation driver takes a signal from the excitation driver corresponding to the current flowing in the excitation winding 2A' and feeds the signal via an integrator filter 13 and an H-bridge driver 14 into the compensation winding 2B, thus providing a negative feedback operation similar to that described in the context of the AC zero-flux current sensor.

The magnetic field H induced from the current *I*_{P} to be measured in the conductor 5 is compensated by a current flowing through the compensation winding 2B. The excitation winding 2A', located at one part of the core 1, detects the magnetic flux within the core 1. This excitation winding 2A' delivers the signal to the amplifier (comprising the excitation driver 12, the integrator filter 13, and the H-bridge driver 14) that drives a compensation current through the compensation winding 2B, bringing the magnetic flux back to zero. Then, the voltage of the compensation current, which can be measured between the terminals of a shunt resistor 11, is proportional to the current *I*_{P} to be measured. The circuit according to Fig. 3 allows for current measurements over wide frequency ranges, including direct current (DC), and thus proves suitable for measuring the currents typically generated by batteries. These types of devices offer a contact-free method, as well as excellent galvanic isolation performance combined with high resolution, accuracy, and reliability.

### Integration of current sensors into a PCB

Each of the above-described current sensors comprises at least one winding or coil (formed of a wire) and a core (preferably being made of a soft magnetic material). Windings can be integrated into a printed circuit board (PCB), for example, by using a PCB with different layers. A winding typically extends along a certain length (along a virtual longitudinal center axis, which is at the same time the center axis of the core) and comprises several turns wound around the core. Each of the turns is a non-closed loop, i. e., it has a first and a second end that are offset with regard to a chosen direction or orientation of the center axis. Alternatively, the offset may be realized with regard to a direction perpendicular to the center axis. However, with regard to a given rotating direction (i. e., in a clockwise manner or, alternatively, counter-clockwise manner when viewed along said chosen direction / orientation of the longitudinal center axis), the second end of each turn is connected to the first end of the next turn (if any), thus forming a winding. The first end of the first turn and the second end of the last turn form the terminals of the winding. Of course, the length of the wire the winding is made of can be longer than the sum of the lengths of all turns, resulting in loose ends leading away from the winding to facilitate the connection of the winding with other electronic components.

In the following, different possibilities for implementing a winding (with or without a core) are described. For the sake of simplicity, the geometry of the windings is described with regard to a (virtual) straight line referred to as a longitudinal center axis. However, the functionality of the winding as an inductivity is preserved when deforming the geometry of the winding by replacing the longitudinal (i. e., linear) center axis by a curved line. This would be the case, for example, when the core has a ring-shaped form with curved parts and the winding is wound around a part of the ring-shaped core.

One way of integrating a winding with a predefined number of N turns into a PCB having at least two layers is to implement the winding into the PCB such that its longitudinal center axis extends within the PCB, in other words, that the center axis is parallel to the plane of the PCB. Then, the PCB comprises two (neighbored) layers, wherein on one of the layers, one half of each turn of the winding is realized as an essentially straight line, and on the other layer, the other half of each turn is realized likewise as an essentially straight line. Thus, each of the two neighbored layers comprises N lines printed in parallel. The lines are of equal length and arranged such on the layers that they extend perpendicular to the center axis. The lines on one of the layers may be arranged such on that layer that they are offset to the lines on the other layer with regard to the chosen direction / orientation of the center axis. Each line has a first and a second end. Except for the first and the last line (with regard to the chosen direction / orientation of the center axis), each line, being realized on one of the two neighbored layers, is connected with its ends to two different lines on the other layer, the latter lines being arranged neighbored to each other on the other layer, such that each pair of a line on one layer and a neighbored (with regard to said direction / orientation of the center axis) line on the other layer forms a turn, and the entirety of these turns forms one winding being realized on the two neighbored layers. In other words, the winding is assembled of two parts: One part, comprising one half of each turn, is arranged on one layer, the other part, comprising the other halves of each the tuns, is arranged on a neighbored layer. Then, the winding extends with its center axis in parallel to the plane of the PCB.

A core (or a part of a core) of a flat shape may be arranged between the above-described two neighbored layers of the PCB along the center axis such that the winding formed of the turns as described above winds around the (part of the) core. The core may have a bore or through-hole suitable for passing a conductor, e. g., a busbar, thought the core, the conductor being electrically isolated from the material of the core.

A second way of integrating a winding into a PCB is to use a PCB having a plurality of parallel layers, wherein on each of the layers - or at least on each layer of a subset of the layers of the PCB - is formed one turn. The turns are formed around a (virtual) longitudinal center axis perpendicular to the layers and may be of essentially equal shape and equal size. Then, each turn has a first end and a second end with regard to a given rotating direction (i. e., in a clockwise manner or, alternatively, counter-clockwise manner when viewed in a predefined direction / orientation along the longitudinal center axis). Except for the first and the last turn (with regard to said direction of the center axis), each turn is connected with its first end to the second end of the next (with regard to said direction of the center axis) turn and with its second end to the first end of the foregoing (with regard to said direction of the center axis) turn. This way, the entirety of the turns forms a winding that extends with its center axis perpendicular to the plane of the PCB. The first end of the first turn and the second end of the last turn form the terminals of the winding.

Along the center axis of the winding, a core (or a part of which) can be realized in that a hole is arranged in the PCB (i. e., holes are arranged in all the layers of the PCB) and the core is passed through these holes. The core itself may comprise a bore or through-hole suitable for passing a conductor through the core.

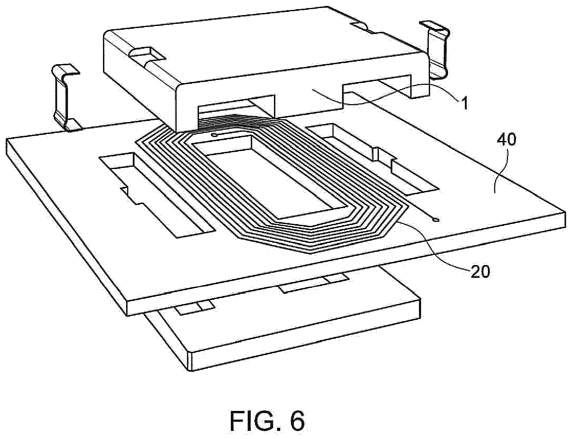

A third way of integrating a winding on a PCB can be realized, which has the advantage that only a single layer of the PCB is required, see Fig. 6. To that end, a number of turns are printed onto the layer starting with an innermost turn, wherein for any turn (except for an outermost turn), a following turn is printed around this turn. Thus, each turn is wound around a (virtual) center axis being perpendicular to the plane of (the layer 40 of) the PCB. One direction R being parallel to the plane of the PCB and perpendicular to the center axis is defined starting at the piercing point of the center axis with the plane of the layer 40 and then leading radially outwards through the starting point (first end) of the innermost turn. Then, for each turn, a first end can be defined at the intersection of this turn with R. The turn is then led, on the layer of the PCB, around the center axis such that it intersects R a second time at a point defined as second end of the turn (possibly except for the outermost turn, for which the second end needs not necessarily be located on *R*). The second end of the turn is offset to the first end of the turn such that the distance of the second end to the center axis is larger than the distance of the first end of that turn to the center axis. For each turn, except for the outermost turn, the second end is connected to the first end of the following turn. Then, the entirety of the turns forms a winding 20 that extends with its turns in parallel to the plane of the PCB and that has a center axis perpendicular to the PCB. The first end of the innermost turn and the second end of the outermost turn are the terminals of the winding 20. In other words, the winding 20 has the shape of a flat spiral that extends on the layer 40 of the PCB; throughout the following, the winding 20 is therefore referred to as a "flat spiral winding."

Along the center axis of the winding, a core 1 (or a part of which) can be realized in that a hole is arranged in the PCB (i. e., holes are arranged in the layers of the PCB) and the core 1 is passed through these holes. The core itself may comprise a bore or through-hole suitable for passing a conductor through the core.

The second way and the third way of integrating a winding on a PCB can be easily combined, provided the PCB comprises a plurality of stacked layers. To that end, on all or at least on several of these layers, a flat spiral winding is formed as described above around a joint (virtual) center axis perpendicular to the (layers of the) PCB. Note that there are two possibilities how a flat spiral winding can be realized on a layer: when a current flows from the inner terminal of the flat spiral winding to its outer terminal, the current may flow (i) in a positive or (ii) in a negative rotational direction with regard to a chosen direction / orientation of the center axis. In case (i), the flat spiral winding shall be referred to as having a positive orientation, whereas in case (ii), the flat spiral winding shall be referred to as having a negative orientation throughout the following. Then, for any one of the flat spiral windings with a positive orientation, the inner terminal is referred to as its first end, and the outer terminal is referred to as its second end throughout the following. For any one of the flat spiral winding with negative orientation, the outer terminal is referred to as its first end, and the inner terminal is referred to as its second end throughout the following.

A complete winding that comprises the turns of any of the flat spiral windings can be obtained as follows: For each of the flat spiral windings, except for the last flat spiral winding (with regard to said chosen direction / orientation of the center axis), its second end is connected to the first end of the next (with regard to said chosen direction / orientation of the center axis) flat spiral winding. Then, the first end of the first flat spiral winding and the second end of the last flat spiral winding are the terminals of the complete winding. Alternatively, for each of the flat spiral windings, except for the last flat spiral winding (with regard to said chosen direction / orientation of the center axis), its first end is connected to the second end of the next (with regard to said chosen direction / orientation of the center axis) flat spiral winding. Then, the second end of the first flat spiral winding and the first end of the last flat spiral winding are the terminals of the complete winding. In both cases holds: the number of the turns of the complete winding equals the sum of the numbers of the turns of the flat spiral windings comprised in the complete winding. Further, when a current flows through the complete winding, the current flows through each of its turns with a like rotational direction (with regard to said chosen direction / orientation of the center axis).

Again, along the center axis of the winding, a core 1 could be realized in that a hole is arranged in the PCB (i. e., holes are arranged in the layers of the PCB) and the core is passed through these holes. The core itself may comprise a bore or through-hole suitable for passing a conductor through the core.

As described in the foregoing section, a fluxgate current sensor is realized using a ring-shaped core and at least one excitation winding 2A' as well as at least one compensation winding 2B wound around said ring-shaped core. According to the invention, a fluxgate current sensor is integrated on the PCB of the BMU of a battery system, thus rendering a design, wherein the fluxgate current sensor requires an implementation separated from the BMU, no longer necessary.

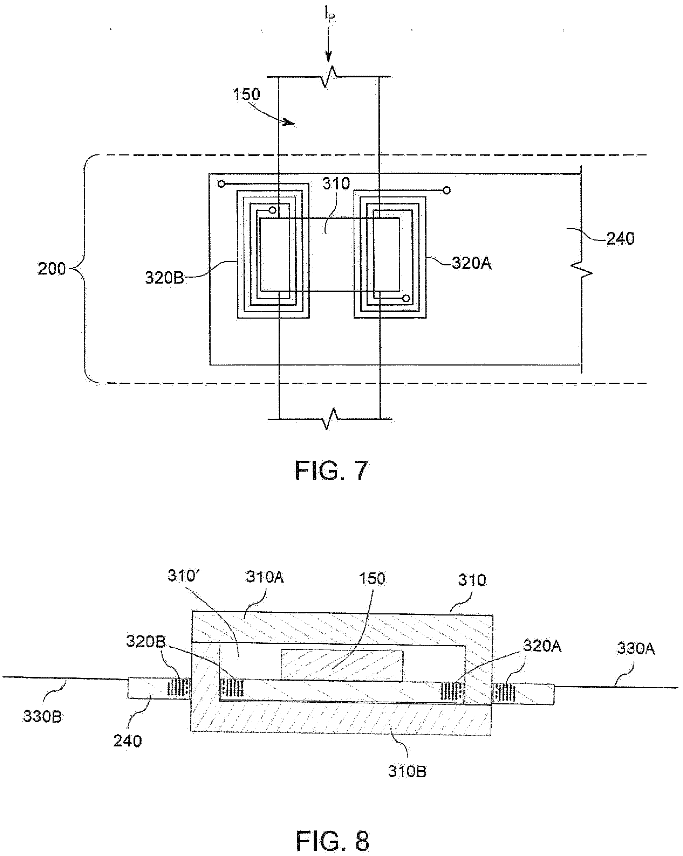

A preferred embodiment of a BMU with a PCB having an integrated current sensor according to the invention is depicted in Fig. 7 (schematic cross sectional view from the top). Here, the current sensor is a closed-loop fluxgate current sensor as described above with reference to Figs. 3, 4A, 4B, 5A, and 5B. The BMU 200 comprises a PCB 240. The PCB 240 comprises one or more layers. The PCB has two holes (without reference number), through which a ring-shaped core 310, made of a material having a high magnetic permeability such as iron or a soft ferrite, is passed. The core 310 may have a rectangular shape with a likewise rectangular through-hole 310' similar to the embodiment illustrated in Fig. 8.

On one of the layers, an excitation winding 320 A is realized in the fashion as described above as the third way of integrating a winding on a PCB and as illustrated in Fig. 6. The excitation winding 320 A is printed on the layer around one of the holes through which the core 310 is passed. The terminals of the excitation winding 320 A are connected with the excitation driver 12 of the sensor electronics 10 of the fluxgate current sensor as depicted in Fig. 3. The sensor electronics 10 is realized on the PCB 240 of the BMU 200.

On one of the layers, a compensation winding 320 B is realized; this layer is the same layer on which the excitation winding 320 A is realized if the PCB comprises only one layer or, if the PCB comprises several layers, may also be a different layer. The compensation winding 320 B is realized in the fashion as described above as a third way of integrating a winding on a PCB and as illustrated in Fig. 6. The compensation winding 320 B is printed on the layer around one of the holes through which the core 310 is passed. The terminals of the compensation winding 320 B are connected with the terminals of the shunt resistor 11 of the sensor electronics 10 of the fluxgate current sensor.

Through the through-hole 310' of the core 310, a busbar 150 of a battery system 100 is passable. Fig. 7 shows the state in which the busbar 150 is passed through said through-hole 310'. When a current *I_{P}* flows through the busbar 150, a magnetic field is generated around the busbar 150 that yields a magnetic flux in the core 310. This magnetic flux is then measurable using the techniques as described above regarding the fluxgate current sensor.

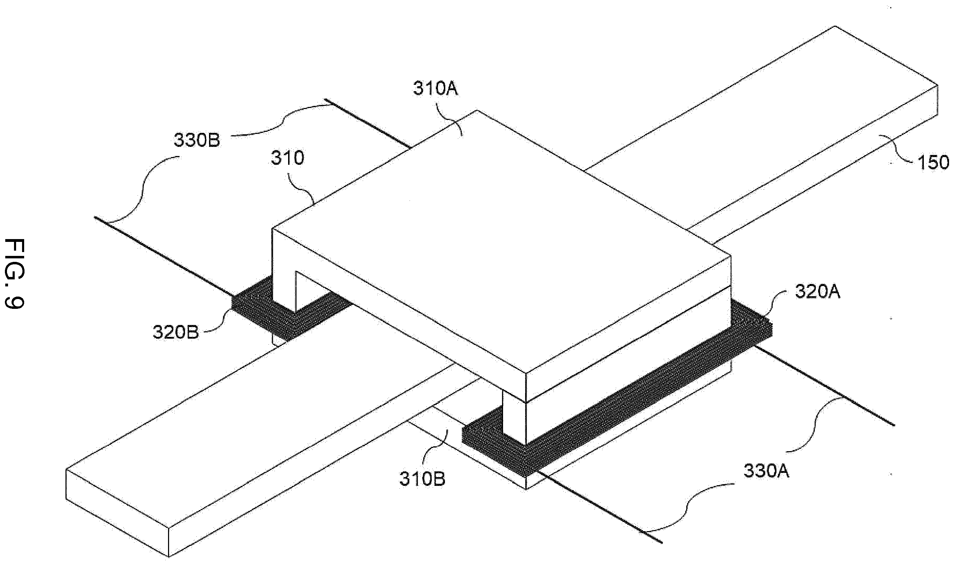

Another preferred embodiment of a BMU with a PCB having an integrated current sensor according to the invention is depicted in Fig. 8 (longitudinal cut) and Fig. 9 (3-dimensional view). This embodiment is similar to the previously described embodiment of Fig. 7 except for the feature that the PCB 240 necessarily comprises a plurality of layers, and the excitation winding 320 A as well as the compensation winding 320 B are each realized on several layers, typically on 6 layers, in a manner as described above as a second way of integrating a winding on a PCB. The connection of the windings 320 A, B to the sensor electronics 10 and the location of the latter is identical to the previously described embodiment. The terminals 330 A of the excitation winding 320 A and the terminals 330 B of the compensation winding 320 B are also depicted in Figs. 8 and 9.

The core 310 may have a rectangular shape with a likewise rectangular through-hole 310'. In particular, the core 310 may comprise two U-shaped or L-shaped parts 310 A and 310 B being configured such that the U-shaped or L-shaped parts 310 A and 310 B can be assembled so as to form the core 310. In case of a rectangular-shaped core 310, the edge(s) of the "U" or "L" have/has, of course, to be considered not as being rounded, but as edge(s) having a right-angled cross-section. Upon assembling the core 310, the arms of the U-shaped or L-shaped parts 310 A and 310 B can be passed through the holes in the PCB to facilitate the manufacturing of the BMU. Preferably, the two U-shaped or L-shaped parts 310 A and 310 B are held together when the core 1 is assembled by using at least two spring brackets 380 A, 380 B. Alternatively or additionally, the two U-shaped or L-shaped parts may be held together by an adhesive and/or the BMU's housing.

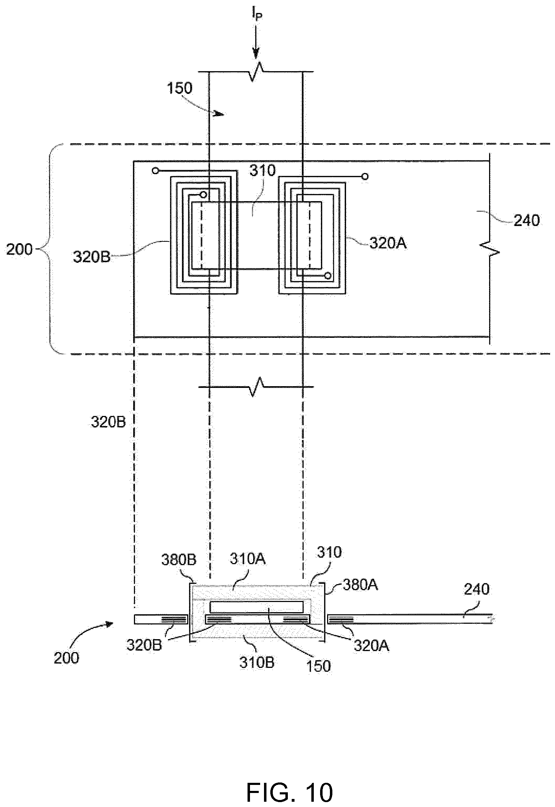

Still another preferred embodiment of a BMU with a PCB having an integrated current sensor according to the invention realizes the implementation of the windings as described above as a combination of the second and third way of integrating a winding on a PCB with several layers, for example six layers (cf. Fig. 10). This has the particular advantage that the number of turns of the windings can be increased in comparison to each of the afore-described embodiments, while at the same time maintaining a compact, space-saving design of the windings on the PCB. For the excitation winding 320 A as well as for the compensation winding 320 B, a flat spiral winding is realized on each layer of the PCB. Then, a cross-sectional view of the design appears like the view of Fig. 7, and a longitudinal cut appears like the view of Fig. 8. The sensor electronics and the connection of the windings with the sensor electronics is realized as in the afore-described embodiments.

A person of skill in the art should recognize that the functionality of various computing devices may be combined or integrated into a single computing device, or the functionality of a particular computing device may be distributed across one or more other computing devices without departing from the scope of the exemplary embodiments of the present invention.

### Reference signs

- 1: magnetic core
- 2: secondary winding
- 2 A: detection winding
- 2 A': excitation winding
- 2 B: compensation winding
- 5: conductor ("primary side")
- 8: excitation circuit
- 9: compensation circuit
- 10: sensor electronics
- 11: shunt resistor
- 11 A, B: terminals of shunt resistor
- 12: excitation driver
- 13: integrator filter
- 14: H-bridge driver
- 15: operational (differential) amplifier

- 20: winding, printed on one layer of a PCB
- 40: layer of a PCB

- 150: busbar
- 200: battery management unit (BMU)
- 240: printed circuit board (PCB) of the BMU

- 310: magnetic core
- 310 A: upper part of magnetic core 310 ("upper" with respect to Fig. 8)
- 310 B: lower part of magnetic core 310 ("lower" with respect to Fig. 8)
- 310': through-hole through magnetic core
- 320 A: excitation winding
- 320 B: compensation winding
- 330 A, B: terminals for the windings
- 380 A, B: spring brackets

## Claims

1. A battery management unit (200) for a battery system with a conductor or busbar (150), the battery management unit (200) comprising:
a printed circuit board (240) and
a fluxgate current sensor, the fluxgate current sensor comprising:
a magnetic core (310) with a through-hole (310');
at least one excitation winding (320 A);
at least one compensation winding (320 B);
a sensor electronics (10);
wherein the at least one excitation winding (320 A) is wound around the magnetic core (310) and the at least one compensation winding (320 B) is wound around the magnetic core (310);
wherein the sensor electronics (10) is configured to measure the magnetization of the excitation winding(s) (320 A), to generate a driving signal for driving the compensation winding(s) (320 B) such that the magnetic flux in the magnetic core (310) is cancelled out by the current in the compensation winding(s) (320 B), to generate a current flowing through the compensation winding(s) (320 B) according to the driving signal, and to generate an output signal corresponding to the magnitude of an electric current *I*_{P} flowing through the through-hole (310') of the magnetic core (310); and
the battery management unit (200) being **characterized in that** the magnetic core (310), the excitation winding(s) (320 A), the compensation winding(s) (320 B), and the sensor electronics (10) are each integrated into the printed circuit board (240); and
wherein the magnetic core (310) is arranged so on the printed circuit board (240) that the battery management unit (200) is mountable such into the battery system that the conductor or busbar (150) of the battery system passes through the through-hole (310') of the magnetic core (310).

2. The battery management unit (200) according to claim 1, wherein each of the windings (320 A, 320 B) comprises one or more turns, each of the turns extending in parallel to the printed circuit board (240) around a virtual center axis perpendicular to the printed circuit board (240).

3. The battery management unit (200) according to claim 2,
wherein the printed circuit board (240) comprises a plurality of layers;
wherein the layers extend in stacked planes parallel to each other;
wherein, for each of the windings (320 A, 320 B), at most one turn extends per layer; and
wherein, for each of the windings (320 A, 320 B), any two neighbored turns are connected to each other such that the entirety of the turns forms a winding.

4. The battery management unit (200) according to claim 2, wherein, for each of the windings (320 A, 320 B), the turns of the winding are arranged on one layer of the printed circuit board (240) so as to form a flat spiral.

5. The battery management unit (200) according to claim 2,
wherein the printed circuit board (240) comprises a plurality of layers;
wherein the layers extend in stacked planes parallel to each other;
wherein, for each of the windings (320 A, 320 B), on all or a subset of said layers, a flat spiral winding is arranged; and
wherein, for each of the windings (320 A, 320 B), any two neighbored flat spiral windings are connected to each other such that the entirety of the turns forms one winding (320 A, 320 B).

6. The battery management unit (200) according to any one of claims 1 to 5, wherein the magnetic core (310) is, apart from the through-hole (310'), shaped as a cuboid.

7. The battery management unit (200) according to any one of claims 1 to 6, wherein the through-hole (310') has a rectangular cross-section, for example a quadratic cross-section, or an elliptical cross-section, for example a circular cross-section.

8. The battery management unit (200) according to any one of claims 1 to 7, wherein the magnetic core (310) is passed through holes in the printed circuit board (240).

9. The battery management unit (200) according to claim 8,
wherein the number of holes in the printed circuit board (240) is two; and
wherein the magnetic core (310) comprises two U-shaped parts being shaped such that upon assembling the magnetic core (310) using the U-shaped parts, one or both of the U-shaped parts can be passed through the holes in the printed circuit board (240) such that the assembled magnetic core (310) is passed through the two holes in the printed circuit board (240).

10. The battery management unit (200) according to claim 9, wherein the two U-shaped parts of the magnetic core (310) are held together by one or more spring brackets (380 A, 380 B), by an adhesive, or by a housing of the battery management unit (200).

11. The battery management unit (200) according to claim 1,
wherein the printed circuit board (240) comprises two neighbored layers;
the magnetic core is flat and positioned between the two layers;
each of the layers of the printed circuit board (240) comprises a through-hole;
the through-hole of the magnetic core and the through-holes of the layers are located such relative to each other that a conductor or busbar (250) can be passed at a time through any one of these through-holes along a virtual center axis perpendicular to the printed circuit board (250); and
wherein, for each of the windings (320 A, 320 B), one half of each complete turn is arranged on one of said two layers and the other half of each complete turn is arranged on the other of said two layers.

12. The battery management unit (200) according to claim 11, wherein the flat magnetic core is formed as a rectangle, a square, an ellipse, or a circle.

13. The battery management unit (200) according to claim 11 or 12, wherein the through-hole in the flat magnetic core and the through-holes in the layers of the printed circuit board are each formed as a rectangle, a square, an ellipse, or a circle.

14. A battery system, comprising:
the battery management unit (200) according to any one of claims 1 to 13;
a conductor or busbar (150);
wherein the conductor or busbar (150) is passed through the through-hole (310') of the magnetic core (310).

## Patentansprüche

1. Eine Batteriemanagementeinheit (200) für ein Batteriesystem mit einem Leiter oder einer Sammelschiene (150), wobei die Batteriemanagementeinheit (200) aufweist:
eine Leiterplatte (240) und
einen Fluxgate-Stromsensor, wobei der Fluxgate-Stromsensor Folgendes aufweist:
einen Magnetkern (310) mit einem Durchgangsloch (310');
zumindest eine Erregerwicklung (320 A);
zumindest eine Kompensationswicklung (320 B);
eine Sensorelektronik (10);
wobei die zumindest eine Erregerwicklung (320 A) um den Magnetkern (310) gewickelt ist und die zumindest eine Kompensationswicklung (320 B) um den Magnetkern (310) gewickelt ist;
wobei die Sensorelektronik (10) konfiguriert ist, um die Magnetisierung der Erregerwicklung(en) (320 B) zu messen, ein Ansteuersignal zum Ansteuern der Kompensationswicklung(en) (320 B) derart zu erzeugen, dass der magnetische Fluss im Magnetkern (310) durch den Strom in der/den Kompensationswicklung(en) (320 B) aufgehoben wird, einen durch die Kompensationswicklung(en) (320 B) fließenden Strom gemäß dem Ansteuersignal zu erzeugen und ein Ausgangssignal entsprechend der Größe eines elektrischen Stroms /p, der durch das Durchgangsloch (310') des Magnetkerns (310) fließt, zu erzeugen; und
die Batteriemanagementeinheit (200) **dadurch gekennzeichnet ist, dass** der Magnetkern (310), die Erregerwicklung(en) (320 A), die Kompensationswicklung(en) (320 B) und die Sensorelektronik (10) jeweils in die Leiterplatte (240) integriert sind; und
wobei der Magnetkern (310) derart auf der Leiterplatte (240) angeordnet ist, dass die Batteriemanagementeinheit (200) derart in das Batteriesystem montiert werden kann, dass der Leiter oder die Sammelschiene (150) des Batteriesystems durch das Durchgangsloch (310') des Magnetkerns (310) hindurchgeht.

2. Die Batteriemanagementeinheit (200) nach Anspruch 1, wobei jede der Wicklungen (320 A, 320 B) eine oder mehrere Windungen aufweist, wobei sich jede der Windungen um eine zur Leiterplatte (240) perpendikuläre virtuelle Mittelachse herum parallel zur Leiterplatte (240) erstreckt.

3. Die Batteriemanagementeinheit (200) nach Anspruch 2,
wobei die Leiterplatte (240) eine Vielzahl von Schichten aufweist;
wobei sich die Schichten in gestapelten Ebenen parallel zueinander erstrecken;
wobei sich für jede der Wicklungen (320 A, 320 B) höchstens eine Windung pro Schicht erstreckt; und
wobei für jede der Wicklungen (320 A, 320 B) zwei beliebige benachbarte Windungen derart miteinander verbunden sind, dass die Gesamtheit der Windungen eine Wicklung ausbildet.

4. Die Batteriemanagementeinheit (200) nach Anspruch 2, wobei für jede der Wicklungen (320 A, 320 B) die Windungen der Wicklung auf einer Schicht der Leiterplatte (240) so angeordnet sind, dass sie eine flache Spirale ausbilden.

5. Die Batteriemanagementeinheit (200) nach Anspruch 2,
wobei die Leiterplatte (240) eine Vielzahl von Schichten aufweist;
wobei sich die Schichten in gestapelten Ebenen parallel zueinander erstrecken;
wobei für jede der Wicklungen (320 A, 320 B) auf allen oder einer Teilmenge der besagten Schichten eine flache Spiralwicklung angeordnet ist; und
wobei für jede der Wicklungen (320 A, 320 B) zwei beliebige benachbarte flache Spiralwindungen derart miteinander verbunden sind, dass die Gesamtheit der Windungen eine Wicklung (320 A, 320 B) ausbildet.

6. Die Batteriemanagementeinheit (200) nach einem der Ansprüche 1 bis 5, wobei der Magnetkern (310) mit Ausnahme des Durchgangslochs (310') als Quader ausgebildet ist.

7. Die Batteriemanagementeinheit (200) nach einem der Ansprüche 1 bis 6, wobei das Durchgangsloch (310') einen rechteckigen Querschnitt, beispielsweise einen quadratischen Querschnitt, oder einen elliptischen Querschnitt, beispielsweise einen kreisförmigen Querschnitt, aufweist.

8. Die Batteriemanagementeinheit (200) nach einem der Ansprüche 1 bis 7, wobei der Magnetkern (310) durch Löcher in der Leiterplatte (240) geführt wird.

9. Die Batteriemanagementeinheit (200) nach Anspruch 8,
wobei die Anzahl der Löcher in der Leiterplatte (240) zwei beträgt; und
wobei der Magnetkern (310) zwei U-förmige Teile aufweist, die derart geformt sind, dass beim Zusammenbau des Magnetkerns (310) unter Verwendung der U-förmigen Teile einer oder beide der U-förmigen Teile derart durch die Löcher in der Leiterplatte (240) geführt werden können, dass der zusammengebaute Magnetkern (310) durch die zwei Löcher in der Leiterplatte (240) geführt wird.

10. Die Batteriemanagementeinheit (200) nach Anspruch 9, wobei die zwei U-förmigen Teile des Magnetkerns (310) durch einen oder mehrere Federbügel (380 A, 380 B), durch ein Haftmittel oder durch ein Gehäuse der Batteriemanagementeinheit (200) zusammengehalten werden.

11. Die Batteriemanagementeinheit (200) nach Anspruch 1,
wobei die Leiterplatte (240) zwei benachbarte Schichten aufweist;
der Magnetkern flach ist und zwischen den zwei Schichten positioniert ist;
jede der Schichten der Leiterplatte (240) ein Durchgangsloch aufweist;
das Durchgangsloch des Magnetkerns und die Durchgangslöcher der Schichten derart relativ zueinander angeordnet sind, dass ein Leiter oder eine Sammelschiene (250) zu einem Zeitpunkt entlang einer zur Leiterplatte (250) perpendikulären virtuellen Mittelachse durch ein beliebiges dieser Durchgangslöcher geführt werden kann; und
wobei für jede der Wicklungen (320 A, 320 B) eine Hälfte jeder vollständigen Windung auf einer der besagten zwei Schichten angeordnet ist und die andere Hälfte jeder vollständigen Windung auf der anderen der besagten zwei Schichten angeordnet ist.

12. Die Batteriemanagementeinheit (200) nach Anspruch 11, wobei der flache Magnetkern als Rechteck, Quadrat, Ellipse oder Kreis ausgebildet ist.

13. Die Batteriemanagementeinheit (200) nach Anspruch 11 oder 12, wobei das Durchgangsloch im flachen Magnetkern und die Durchgangslöcher in den Schichten der Leiterplatte jeweils als Rechteck, Quadrat, Ellipse oder Kreis ausgebildet sind.

14. Ein Batteriesystem, aufweisend:
die Batteriemanagementeinheit (200) nach einem der Ansprüche 1 bis 13;
einen Leiter oder eine Sammelschiene (150);
wobei der Leiter oder die Sammelschiene (150) durch das Durchgangsloch (310') des Magnetkerns (310) geführt wird.

## Revendications

1. Unité de gestion de batterie (200) pour un système de batterie avec un conducteur ou une barre omnibus (150), l'unité de gestion de batterie (200) comprenant :
une carte de circuit imprimé (240) et
un capteur de courant détecteur de flux, le capteur de courant détecteur de flux comprenant :
un noyau magnétique (310) avec un trou traversant (310') ;
au moins un enroulement d'excitation (320A) ;
au moins un enroulement de compensation (320B) ;
un composant électronique de capteur (10) ;
où l'au moins un enroulement d'excitation (320A) est enroulé autour du noyau magnétique (310) et l'au moins un enroulement de compensation (320B) est enroulé autour du noyau magnétique (310) ;
où le composant électronique de capteur (10) est configuré pour mesurer la magnétisation de(s) enroulement(s) d'excitation (320A), pour générer un signal de commande pour commander le(s) enroulement(s) de compensation (320B) de sorte que le flux magnétique dans le noyau magnétique (310) soit annulé par le courant dans le(s) enroulement(s) de compensation (320B), pour générer un courant circulant à travers le(s) enroulement(s) de compensation (320B) selon le signal de commande, et pour générer un signal de sortie correspondant à l'intensité d'un courant électrique *I*_{P} circulant à travers le trou traversant (310') du noyau magnétique (310) ; et
l'unité de gestion de batterie (200) étant **caractérisée en ce que** le noyau magnétique (310), le(s) enroulement(s) d'excitation (320A), le(s) enroulement(s) de compensation (320B), et le composant électronique de capteur (10) sont chacun intégrés dans la carte de circuit imprimé (240) ; et
dans laquelle le noyau magnétique (310) est agencé sur la carte de circuit imprimé (240) de sorte que l'unité de gestion de batterie (200) puisse être montée dans le système de batterie de sorte que le conducteur ou la barre omnibus (150) du système de batterie passe à travers le trou traversant (310') du noyau magnétique (310).

2. Unité de gestion de batterie (200) selon la revendication 1, dans laquelle chacun des enroulements (320A, 320B) comprend une ou plusieurs spires, chacune des spires s'étendant parallèlement à la carte de circuit imprimé (240) autour d'un axe central virtuel perpendiculaire à la carte de circuit imprimé (240).

3. Unité de gestion de batterie (200) selon la revendication 2,
dans laquelle la carte de circuit imprimé (240) comprend une pluralité de couches ;
dans laquelle les couches s'étendent dans des plans empilés parallèles les uns aux autres ;
dans laquelle, pour chacun des enroulements (320A, 320B), au plus une spire s'étend par couche ; et
dans laquelle, pour chacun des enroulements (320A, 320B), deux spires voisines quelconques sont connectées l'une à l'autre de sorte que la totalité des spires forme un enroulement.

4. Unité de gestion de batterie (200) selon la revendication 2, dans laquelle, pour chacun des enroulements (320A, 320B), les spires de l'enroulement sont agencées sur une couche de la carte de circuit imprimé (240) de manière à former une spirale plate.

5. Unité de gestion de batterie (200) selon la revendication 2,
dans laquelle la carte de circuit imprimé (240) comprend une pluralité de couches ;
dans laquelle les couches s'étendent dans des plans empilés parallèles les uns aux autres ;
dans laquelle, pour chacun des enroulements (320A, 320B), sur la totalité ou un sous-ensemble desdites couches, un enroulement en spirale plate est agencé ; et
dans laquelle, pour chacun des enroulements (320A, 320B), deux enroulements en spirale plate voisins quelconques sont connectés l'un à l'autre de sorte que la totalité des spires forme un enroulement (320A, 320B).

6. Unité de gestion de batterie (200) selon l'une quelconque des revendications 1 à 5, dans laquelle le noyau magnétique (310) est, hormis le trou traversant (310'), de forme cubique.

7. Unité de gestion de batterie (200) selon l'une quelconque des revendications 1 à 6, dans laquelle le trou traversant (310') a une section transversale rectangulaire, par exemple une section transversale quadratique, ou une section transversale elliptique, par exemple une section transversale circulaire.

8. Unité de gestion de batterie (200) selon l'une quelconque des revendications 1 à 7, dans laquelle le noyau magnétique (310) est passé à travers des trous dans la carte de circuit imprimé (240).

9. Unité de gestion de batterie (200) selon la revendication 8,
dans laquelle le nombre de trous dans la carte de circuit imprimé (240) est de deux ; et
dans laquelle le noyau magnétique (310) comprend deux parties en forme de U qui sont formées de sorte que lors de l'assemblage du noyau magnétique (310) en utilisant les parties en forme de U, une ou les deux parties en forme de U puissent être passées à travers les trous dans la carte de circuit imprimé (240) de sorte que le noyau magnétique (310) assemblé soit passé à travers les deux trous dans la carte de circuit imprimé (240).

10. Unité de gestion de batterie (200) selon la revendication 9, dans laquelle les deux parties en forme de U du noyau magnétique (310) sont maintenues ensemble par un ou plusieurs supports à ressort (380A, 380B), par un adhésif, ou par un boîtier de l'unité de gestion de batterie (200).

11. Unité de gestion de batterie (200) selon la revendication 1,
dans laquelle la carte de circuit imprimé (240) comprend deux couches voisines ;
le noyau magnétique est plat et positionné entre les deux couches ;
chacune des couches de la carte de circuit imprimé (240) comprend un trou traversant ;
le trou traversant du noyau magnétique et les trous traversants des couches sont situés de telle manière l'un par rapport à l'autre qu'un conducteur ou barre omnibus (250) puisse être passé à un moment donné à travers l'un quelconque de ces trous traversants le long d'un axe central virtuel perpendiculaire à la carte de circuit imprimé (250) ; et
dans laquelle, pour chacun des enroulements (320A, 320B), une moitié de chaque spire complète est agencée sur l'une desdites deux couches et l'autre moitié de chaque spire complète est agencée sur l'autre desdites deux couches.

12. Unité de gestion de batterie (200) selon la revendication 11, dans laquelle le noyau magnétique plat est formé comme un rectangle, un carré, une ellipse, ou un cercle.

13. Unité de gestion de batterie (200) selon la revendication 11 ou 12, dans laquelle le trou traversant dans le noyau magnétique plat et les trous traversants dans les couches de la carte de circuit imprimé sont chacun formés comme un rectangle, un carré, une ellipse, ou un cercle.

14. Système de batterie, comprenant :
l'unité de gestion de batterie (200) selon l'une quelconque des revendications 1 à 13 ;
un conducteur ou une barre omnibus (150) ;
dans lequel le conducteur ou la barre omnibus (150) est passé à travers le trou traversant (310') du noyau magnétique (310).
